# EUROPEAN PATENT APPLICATION

(11) **EP 4 624 119 A1**
(43) Date of publication of application: **01.10.2025**
(21) Application number: 22966252.3
(22) Date of filing: 25.11.2022
(51) Int. Cl.: B25J 15/08, B25J 15/02, B25J 15/06, B25J 15/04, B25J 15/10, B25J 9/08, B25J 9/00, B25J 15/00, B65G 49/07, B23Q 7/04, B05C 13/00, B66C 1/28, B66C 1/42, B66C 1/44, H05K 13/04

(54) **GRABBING APPARATUS, AND ROBOT HAVING GRABBING APPARATUS**

(71) Applicant: Shanghai Flexiv Robotics Technology Co., Ltd., Shanghai 200241 (CN); Flexiv Ltd., Grand Cayman, KY1-9010 (KY)
(72) Inventor: COULSON, Ryan, Santa Clara, CA 95054 (US); LI, Wenbin, Santa Clara, CA 95054 (US); JIANG, Hao, Santa Clara, CA 95054 (US)
(74) Representative: Mewburn Ellis LLP
(86) International application number: PCT/CN2022/134404
(87) International publication number: WO 2024/108564

(57) **Abstract**

The present disclosure relates to a gripping device (1) includes a casing (10) and at least two gripping assemblies (20). Each of the gripping assembly (20) includes: a fingertip (21) configured to grip a target object; a connecting rod assembly (22), a first end of which is connected to the fingertip (21), and a second end of which is rotatably connected to the casing (10); and an attaching assembly (23) disposed on a side of the connecting rod assembly (22) facing the target object to be gripped. The gripping device (1) is configured to be switched between a first gripping mode and a second gripping mode. In the first gripping mode, the gripping device (1) clamps the target object by the fingertips (21) cooperating with each other. In the second gripping mode, the gripping device (1) adheres and/or adsorbs the target object by the attaching assemblies (23) cooperating with each other to implement a gripping operation.

## Description

### TECHNICAL FIELD

This disclosure relates to the robotic technology, and in particular, to a gripping device and a robot having the same.

### BACKGROUND

Robots with gripping devices are widely used in many fields such as industrial manufacturing, logistics and transportation, etc. With the continuous development of the technology, the application scenarios of the robots are becoming more diverse. However, the current robots are limited to a single gripping mode, which cannot be adapted to a variety of scenarios.

### SUMMARY

In a first aspect, the present disclosure provides a gripping device. The gripping device includes a casing and at least two gripping assemblies configured to grip a target object cooperatively. Each of the gripping assemblies includes: a fingertip configured to clamp the target object; a connecting rod assembly, a first end of which is connected to the fingertip, and a second end of which is rotatably connected to the casing; and an attaching assembly disposed on a side of the connecting rod assembly facing the target object to be gripped. The gripping device is configured to be switched between a first gripping mode and a second gripping mode. In the first gripping mode, the gripping device clamps the target object by the fingertips cooperating with each other. In the second gripping mode, the gripping device adheres and/or adsorbs the target object by the attaching assemblies cooperating with each other to implement a gripping operation.

In some embodiments, each fingertip is in a first state in the first gripping mode, and each fingertip is in a second state in the second gripping mode. When each fingertip is in the second state, each fingertip is deflected relative to the attaching assembly in a first direction in which the gripping assemblies are away from each other.

In some embodiments, each of the connecting rod assembly includes a first connecting rod, a second connecting rod, a third connecting rod, and a fourth connecting rod. A first end of the first connecting rod is rotatably connected to the casing, and a second end of the first connecting rod is rotatably connected to the second connecting rod. A first end of the second connecting rod is rotatably connected to the first connecting rod, and a second end of the second connecting rod is rotatably connected to a first end of the third connecting rod. A first end of the third connecting rod is connected to the second end of the second connecting rod, and a second end of the third connecting rod is connected to the fingertip. A first end of the fourth connecting rod is connected between the first end of the second connecting rod and the fingertip, and a second end of the fourth connecting rod is rotatably connected to the casing. The attaching assembly is disposed on a side of the fourth connecting rod facing the target object to be gripped.

In some embodiments, the connecting rod assembly further comprises a first locking assembly, and in the first gripping mode, the first connecting rod and the second connecting rod of are locked in a same line by the first locking assembly.

In some embodiments, the connecting rod assembly further comprises a second locking assembly, and in the second gripping mode, the third connecting rod and the fourth connecting rod are locked with a predetermined angle therebetween by the second locking assembly.

In some embodiments, the casing further includes first limiting elements and second limiting elements. The first limiting elements and the second limiting elements are respectively disposed on two sides of the fourth connecting rods. The first limiting elements are configured to limit rotation ranges of the fourth connecting rods in the first direction when the gripping assemblies are rotated away from each other in the first direction, and the second limiting elements are configured to limit rotation ranges of the fourth connecting rods in a second direction when the gripping assemblies are moving close to each other in the second direction.

In some embodiments, each connecting rod assembly further comprise a first locking assembly and a second locking assembly, and the casing further comprises a first limiting element and a second limiting element. The first locking assembly is configured to lock the first connecting rod and the second connecting rod in a same line in the first gripping mode, and the second locking assembly is inactive in the first gripping mode. The second locking assembly is configured to lock the third connecting rod and the fourth connecting rod with a predetermined angle therebetween in the second gripping mode, and the first connecting rod and the second connecting rod are released from the locking of the first locking assembly. The first limiting element and the second limiting element are disposed on two sides of the fourth connecting rod. During switching of the gripping device from the first gripping mode to the second gripping mode, the first limiting elements are configured to limit rotation ranges of the fourth connecting rods in the first direction when the gripping assemblies are rotated away from each other in the first direction, such that the first connecting rod and the second connecting rod are released from the locking of the first locking assembly to rotate relative to each other, and the third connecting rod rotates relative to the fourth connecting rod in the first direction to the predetermined angle and are locked by the second locking assembly. During switching the gripping device from the second gripping mode to the first gripping mode, the second limiting elements are configured to limit rotation ranges of the fourth connecting rods in a second direction when the gripping assemblies move close to each other in the second direction, such that the first connecting rod drives the third connecting rod to rotate when the first connecting rod continues to rotate in the second direction, causing the second locking assembly to unlock the third connecting rod and the fourth connecting rod and causing the first locking assembly to lock the first connecting rod and the second connecting rod.

In some embodiments, the connecting rod assemblies each comprises a first connecting rod, a second connecting rod, and a third connecting rod. A first end of the first connecting rod is rotatably connected to the casing, and a second end of the first connecting rod is rotatably connected to a first end of the second connecting rod. A second end of the second connecting rod is rotatably connected to the fingertip. A first end of the third connecting rod is rotatably connected between the second end of the second connecting rod and the fingertip, and a second end of the third connecting rod is rotatably connected to the casing. The attaching assembly is disposed on a side of the third connecting rod facing the target object to be gripped.

In some embodiments, the casing further includes a first fixing element and a second fixing element, the attaching assemblies are connected between the casing and the fingertip by the first fixing element and the second fixing element, the attaching assemblies each having a substantially constant loading force.

In some embodiments, at least one of the first fixing element and the second fixing element is configured to provide the substantially constant loading force to the attaching assembly, such that the attaching assembly remains in a tensioned state during movement of the gripping assemblies.

In some embodiments, the attaching assemblies are each mounted on one side of the connecting rod assembly facing the target object to be gripped by means of attachment fixation.

In some embodiments, the attaching assemblies are gecko adhesive material films.

In some embodiments, the attaching assemblies are fixedly attached to the connecting rod assemblies by means of a cushion, respectively.

In a second aspect, the present disclosure provides a robot with a gripping device. The robot includes the gripping device of any one of the embodiments as described above.

The above description is only a summary of the technical solution of the present disclosure. In order to make the technical solutions of this disclosure more clear and implementable in accordance with the specification, and in order to make the above and other purposes, features and advantages of this disclosure more obvious and understandable, the following specific embodiments of this disclosure are provided

### BRIEF DESCRIPTION OF THE DRAWINGS

In order to illustrate the technical solutions in the embodiments of the present disclosure or relative art more clearly, the accompanying drawings used in the description of the embodiments or relative art will be briefly introduced below. Apparently, the accompanying drawings in the following description are only some embodiments of the present disclosure. For those of ordinary skill in the art, other drawings can also be derived from these drawings without creative effort.
FIG. 1 is a schematic perspective view of a steric structure of a gripping device in which a casing is partially removed according to an embodiment of the present disclosure.
FIG. 2 is a schematic front view of the gripping device shown in FIG. 1.
FIG. 3 is a cross-sectional view of part of a gripping assembly and the casing of the gripping device shown in FIG.1.
FIG. 4 is a cross-sectional view of a fourth connecting rod of the gripping device shown in FIG. 1.
FIGS. 5a-5b are equivalent schematic diagrams of gripping assemblies of the gripping device shown in FIG. 1 when gripping in a first gripping mode.
FIGS. 6a-6c are equivalent schematic diagrams of gripping assemblies of the gripping device shown in FIG. 1 when switched from a first gripping mode to a second gripping mode.
FIGS. 7a-7b are equivalent schematic diagrams of gripping assemblies of the gripping device shown in FIG. 1 in a second gripping mode.
FIGS. 8a-8c are equivalent schematic diagrams of gripping assemblies of the gripping device shown in FIG. 1 when switched from a second gripping mode to a first gripping mode.
FIG. 9 is an equivalent schematic diagram of a structure of gripping assemblies of a gripping device according to another embodiment of the present disclosure.

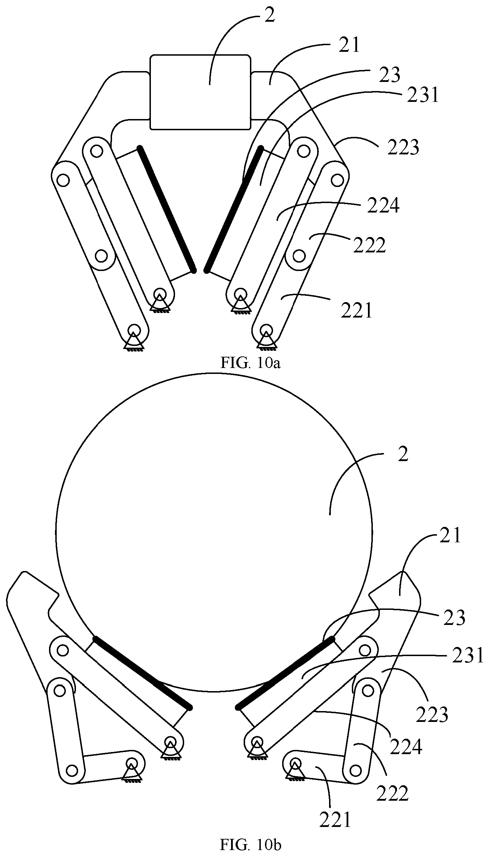

FIGS. 10a-10b are equivalent schematic diagrams showing operating states of the gripping assemblies of the gripping device shown in FIG. 9 in a first gripping mode and a second gripping mode, respectively.
FIG. 11 is a schematic diagram of a structure of gripping assemblies of a gripping device in a first gripping mode according to another embodiment of the present disclosure.
FIG. 12 is an equivalent schematic diagram of a structure of the gripping assemblies of the gripping device shown in FIG. 11 in a second gripping mode.
FIG. 13 is a schematic diagram of a structure of a robot according to an embodiment of the present disclosure.

### DETAILED DESCRIPTION OF THE EMBODIMENTS

Embodiments of the present disclosure will be described in detail below with reference to the accompanying drawings. The embodiments described herein are only used to illustrate the technical solutions of the present disclosure more clearly. Therefore, the embodiments are only used as examples, but not to limit the scope of the present disclosure. Other embodiments obtained based on the embodiments in the present disclosure without creative labor by a person of ordinary skill in the art fall within the protection scope of the present disclosure.

Unless otherwise defined, all technical and scientific terms used herein have the same meaning as commonly understood by one of ordinary skill in the art to which this disclosure belongs. The terms herein are only used to illustrate the specific embodiments, but are not intended to limit the disclosure. The terms "include", "have" and any variations in the specification, the claims, and the description of the drawings of the present disclosure are intended to cover non-exclusive inclusion.

In the description of the embodiments of the present disclosure, the terms "first", "second", etc. are used only to distinguish different objects, but cannot be construed as indicating or implying the relative importance or implicitly indicating the number, the particular order or the priority of the indicated technical features. In the description of the embodiments of the present disclosure, the term "plurality" means more than two (including two), unless otherwise specifically limited.

The description of the term "embodiment" is intended to refer to a specific feature, a configuration, a material, or a characteristic described included in at least one embodiment of the present disclosure. The phrase that appears at various positions in the specification does not necessarily refer to the same embodiment, nor is it a separate or an alternative embodiment mutually exclusive with other embodiments. It should be understood, both explicitly and implicitly, by those of skill in the art that the embodiments described herein may be combined with other embodiments.

In the description of the embodiments of the present disclosure, the term "and/or" is only a description of an association relationship of the association objects, which indicates that there can be three relationships. For example, A and/or B may indicate the following three cases: a single existence of A, an existence of both A and B, and a single existence of B. In addition, the character "/" in the description generally indicates that the context object is an "or" relationship.

In the description of the present disclosure, the term " multiple" refers to more than two (including two), and similarly, "multi-group" refers to more than two groups (including two groups), and " multi-pieces" refers to more than two pieces (including two pieces).

In the description of the embodiments of the present disclosure, unless otherwise defined, the technical terms "mounted", "connected", "fixed", etc. should be understood in a broad sense, e.g., it may be a fixed connection, a removable connection, or integrated. It may also be a mechanical connection or an electrical connection. It may also be a direct connection or an indirect connection through an intermediate medium. It may also be an internal connection of two components or an interaction between two components. To those of ordinary skill in the art, the specific meaning of the above terms in the embodiments of the present disclosure can be understood according to specific conditions.

At present, robots with gripping devices are widely used in various fields such as industrial manufacturing, logistics and transportation, etc. For example, in the industrial manufacturing field, robotic grippers are used to grip and install components. In the logistics field, robotic grippers are used to grip and move items. However, the applicant has noted that there is a single gripping mode of the current robots, which cannot be adapted to multiple scenarios. For example, the robotic grippers in the industrial manufacturing grip the components through mechanical fingers similar to human fingers, which can realize a high accuracy and reliability. However, in such a gripping mode, large objects may not be gripped due to a limitation of a travel range of the mechanical fingers. In addition, deformable or fragile objects may be damaged due to a large clamping force of the mechanical fingers. Therefore, additional robots of different types may be required for such large objects, or deformable or fragile objects, which increases the complexity and the cost of automated industrial manufacturing.

In response to the problem that the single gripping mode of the robots cannot be adapted to multiple scenarios, the applicant has designed a gripping device after research. The gripping device can be used in robotics, and is able to be switched between different gripping modes. The gripping device includes a casing and at least two gripping assemblies. The at least two gripping assemblies are configured to be driven by a drive device to cooperatively grip a target object. Each of the gripping assembly includes: a fingertip configured to clamp the target object; a connecting rod assembly, a first end of which is connected to the fingertip, and a second end of which is rotatably connected to the casing; and an attaching assembly mounted on a side of the connecting rod assembly facing the target object to be gripped. The attaching assembly is configured to perform a gripping operation by contacting a surface of the target object to be gripped by means of adhesion and/or adsorption, etc. The gripping device is capable of being switched between a first gripping mode and a second gripping mode. In the first gripping mode, the gripping device clamps the target object by each of the fingertips. In the second gripping mode, the gripping device adheres and/or adsorbs the target object by each of the attaching assemblies to implement a gripping operation. Therefore, the gripping device can be switched between different gripping modes for different application scenarios.

The concept of the present disclosure will be described in detail below with reference to the embodiments. The gripping device disclosed in each embodiment of the present disclosure can be applied to, but is not limited to, robotic arms or robots in the fields of industrial manufacturing, logistics and transportation, etc. The gripping assemblies of the gripping device are driven by a drive device and cooperate with each other to implement the gripping operation. In this disclosure, there is no limitation to the driving method for the gripping assemblies, as long as the gripping assemblies can implement an opening operation and a closing operation, and cooperate with each other to implement the gripping operation. For example, each gripping assembly may be driven by a plurality of linked connecting rods to implement the opening operation and the closing operation, or driven by means of tendons to implement the opening operation and the closing operation. Tendon driving is prior art and will not be described in detail herein.

The present disclosure will be described below with reference to exemplary embodiments of the gripping device in which gripping assemblies are driven to be open or closed by a plurality of linked connecting rods to achieve gripping.

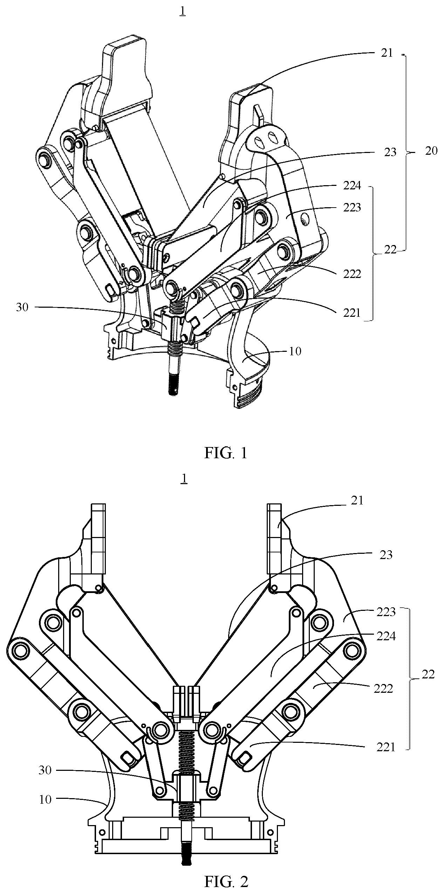

FIGS. 1-4 are schematic diagrams showing the structure of the gripping device in some embodiments of the present disclosure. The gripping device 1 includes a casing 10, at least two gripping assemblies 20, and a drive device 30. The at least two gripping assemblies 20 are configured to be driven by the drive device 30 to cooperatively grip a target object. Each gripping assembly 20 includes a fingertip 21, a connecting rod assembly 22, and an attaching assembly 23. In each gripping assembly 20, the fingertip 21 is configured to clamp the target object, a first end of the connecting rod assembly 22 is connected to the fingertip 21, and a second end of the connecting rod assembly 22 is rotatably connected to the casing 10. The attaching assembly 23 is disposed on at least one side of the connecting rod assembly 22 facing the target object to be gripped (i.e., an inner side of the gripping assembly), and configured to make contact with the surface of the target object to be gripped by means of adsorption and/or adhesion to achieve the gripping of the target object. The gripping device 1 can be switched between a first gripping mode and a second gripping mode. In the first gripping mode (also referred to as fingertip gripping mode), the gripping device 1 clamps the target object by each of the fingertips 21 in cooperation with each other. In the second gripping mode (also referred to as attachment gripping mode), the gripping device 1 adheres and/or adsorbs the target object by each of the attaching assemblies in cooperation with each other to implement the gripping operation.

In the present disclosure, by providing the fingertip at one end of each gripping assembly 20, and providing the attaching assembly on the inner side of each gripping assembly 20, the gripping device 1 has different gripping modes. In the fingertip gripping mode, a high precision gripping operation can be achieved by the fingertips. For example, a small-sized component, etc. at a specific location can be gripped by the fingertips. In the attachment gripping mode, large target objects, or deformable or fragile target objects can be gripped by adsorption and/or adhesion forces, so that the target objects can be gripped with minimum pressure, and are less likely to be damaged, and the gripping operation is not limited by the travel range of the gripper device. The gripping device 1 can be switched between different gripping modes for different application scenarios, which can reduce the cost and the complexity of assembly lines in industrial manufacturing or logistics and transportation, and improve gripping efficiency.

It should be noted that in some embodiments of the present disclosure, the quantity of the gripping assemblies 20 can be set according to actual needs. The structures of the gripping assemblies 20 may be the same, and the structure of one of the gripping assemblies will be described below as an example.

With continuous reference to FIGS. 1-4, in an embodiment, each gripping assembly 20 includes a fingertip 21, a connecting rod assembly 22 with four connecting rods, and an attaching assembly 23. By adjusting the position relationship between the four connecting rods, each gripping assembly 20 can be switched between the first gripping mode and the second gripping mode, and each fingertip 21 can be switched between a first state and a second state.

In detail, each connecting rod assembly 221 includes a first connecting rod 221, a second connecting rod 222, a third connecting rod 223, and a fourth connecting rod 224. A first end of the first connecting rod 221 is rotatably connected to the casing 10, and a second end of the first connecting rod 221 is rotatably connected to a first end of the second connecting rod 222. A second end of the second connecting rod 222 is rotatably connected to a first end of the third connecting rod 223. The third connecting rod 223 is fixedly connected to the fingertip 21. In some embodiments, the third connecting rod 223 may be integrally formed with the fingertip 21. A first end of the fourth connecting rod 224 is rotatably connected to a second end of the third connecting rod 223, and a second end of the fourth connecting rod 224 is rotatably connected to the casing 10.

In the fingertip gripping mode, the first connecting rod 221 and the second connecting rod 222 are locked in a same line, such that the fingertip is located in the first state, i.e., the orientation of a gripping surface of each fingertip 21 keeps unchanged while the gripping assemblies 20 are moving close to each other or moving away from each other. The drive device 30 is configured to drive the first end of the first connecting rods 221 to rotate, so as to drive the gripping assemblies 20 to move close to each other or move away from each other.

In detail, when the gripping device 1 is in the fingertip gripping mode, the first connecting rod 221 and the second connecting rod 222 are locked in the same line parallel to the fourth connecting rod 221, and a sum of the length of the first connecting rod 221 and the length of the second connecting rod 222 (i.e. a distance from the first end of the first connecting rod 221 to the second end of the second connecting rod 222 in this case) is equal to the length of the fourth connecting rod 224 (i.e. a distance from the first end of the fourth connecting rod 224 to the second end of the fourth connecting rod 224). A rod-like structure formed by the first connecting rod 221 and the second connecting rod 222 in the same line, the third connecting rod 223, the fourth connecting rod 224, and a portion of the casing form a parallelogram linkage structure. Each fingertip 21 is in the first state. The first connecting rods 221 or the fourth connecting rods 224 can be driven by the drive device 30 to rotate, so as to drive the at least two gripping assemblies 20 to move in opposite directions, causing the fingertips 21 to move close to each other or move away from each other accordingly, thereby gripping or releasing the target object.

In some embodiments, each connecting rod assembly 22 further includes a first locking assembly 225. The first locking assembly 225 is configured to lock the first connecting rod 221 and the second connecting rod 222 in the same line in the fingertip gripping mode.

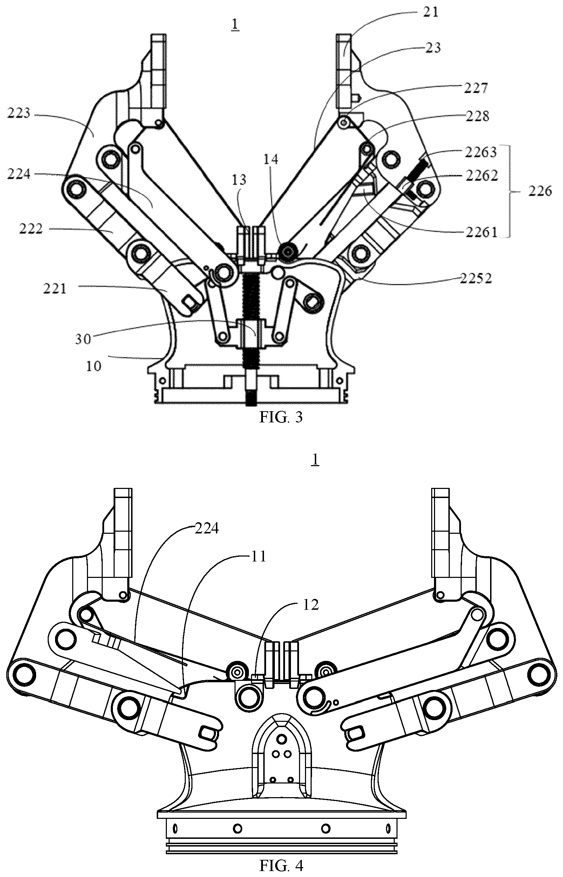

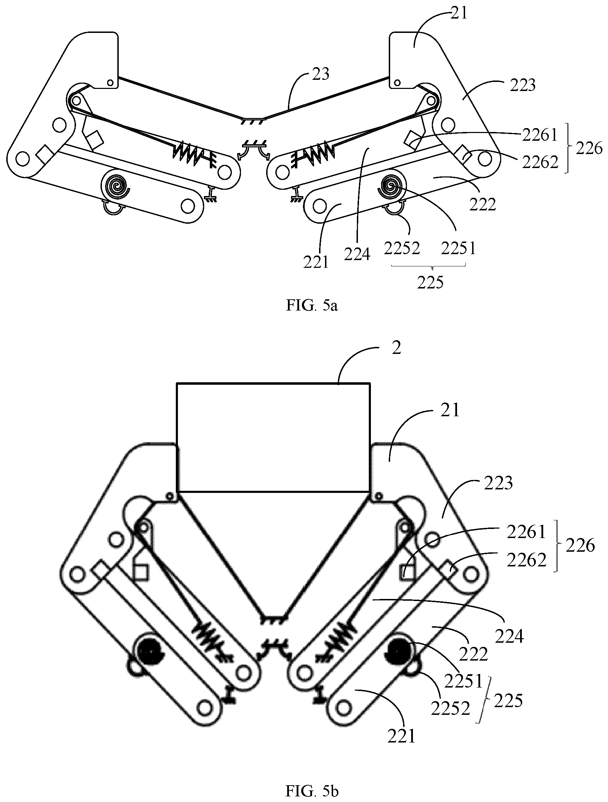

For example, referring to FIG. 3 and FIG. 5a, in some embodiments, the first locking assembly 225 is provided between the first connecting rod 221 and the second connecting rod 222. The first locking assembly 225 includes a first elastic element 2251 (as shown in FIG. 5a) and a first stop element 2252. The first elastic element 2251 may be preloaded and provided between the first connecting rod 221 and the second connecting rod 222. The first elastic element 2251 is configured to provide a torsional force to the first connecting rod 221 and the second connecting rod 222, such that the second connecting rod 222 has a tendency to deflect relative to the first connecting rod 221 in a first direction towards an outer side of the gripping assembly. In the embodiments of the present disclosure, the direction towards the outer side of the gripping assembly (i.e., the direction in which the gripping assemblies are away from each other) is referred to as the first direction, and the direction towards the inner side of the gripping assembly (i.e., the direction in which the gripping assemblies are close to each other) is referred to as a second direction.

For example, in some embodiments, the first elastic element 2251 may be a torsion spring. One end of the torsion spring is connected to the first connecting rod 221, and another end of the torsion spring is connected to the second connecting rod 222. The first stop element 2252 is a stoper protruding from the end of the first connecting rod 221 connected to the second connecting rod 222. The first stop element 2252 is configured to limit a rotation range between the first connecting rod 221 and the second connecting rod 222, thereby preventing the deflection of the second connecting rod 222 relative to the first connecting rod 221 in the first direction. The first elastic member 2251 and the first stop element 2252 work together to keep the first connecting rod 221 and the second connecting rod 222 in the same line in the fingertip gripping mode. In another embodiment, the first stop element 2252 may also be disposed on the second connecting rod 222, as long as the relative rotation between the first connecting rod 221 and the second connecting rod 222 is limited. It should be understood that the elastic force of the first elastic element 2251 (e.g., the torque spring) can be set and adjusted according to actual situations, such that, the elastic force generated by the first elastic element 2251 is large enough to prevent the second connecting rod 222 from deflecting in the first direction relative to the first connecting rod 221 during the clamping and/or releasing of the target object in the first gripping mode of the gripping device, and the driving device 30 can overcome the elastic force of the first elastic element 2251 without damage when the gripping device switches to the second gripping mode.

For another example, in some embodiments, the first elastic element is an extension spring. One end of the extension spring is fixed to the casing 10, and another end of the extension spring is fixed to the fourth connecting rod 224. The extension spring is configured to provide a continuous tension force to the fourth connecting rod 224 towards the casing 10 within the motion range of the gripping device. Similarly, the extension spring causes the fourth connecting rod 224 to have a tendency to deflect in the first direction relative to the casing 10. Since the fourth connecting rod 224, the third connecting rod 223 and the second connecting rod 222 are connected in sequence, the fourth connecting rod 224 drives the second connecting rod 222, so that the second connecting rod 222 has a tendency to deflect in the first direction relative to the first connecting rod 221. In this embodiment, the first stop element 2522 is also provided to prevent the deflection of the second connecting rod 222 relative to the first connecting rod 221 in the first direction. Thus, the extension spring cooperates with the first stop element 2252 to keep the first connecting rod 221 and the second connecting rod 222 in the same line in the fingertip gripping mode.

For another example, in some embodiments, if the first elastic element is an extension spring, one end of the extension spring is connected to the casing 10, and another end of the extension spring may be connected to the second connecting rod 222. The extension spring is configured to provide a continuous tension force to the second connecting rod 222 towards the casing 10 within the motion range of the gripping device, thus the second connecting rod 222 has a tendency to deflect in the first direction relative to the first connecting rod 221. In this embodiment, the first stop element 2252 is also provided to prevent the deflection of the second connecting rod 222 relative to the first connection rod 221 in the first direction. Thus, the extension spring cooperates with the first stop element 2252 to keep the first connecting rod 221 and the second connecting rod 222 in the same line in the fingertip gripping mode.

It should be understood that in some other embodiments, if the first elastic element is an extension spring, one end of the extension spring may be connected to the casing 10, and another end of the extension spring may be connected to the third connecting rod 223, the principle of which is similar to the two aforementioned embodiments and will not be repeated here.

By setting the first locking assembly, the structure of the gripping assembly is more stable in the fingertip gripping mode.

In some other embodiments, the relative rotation and the position locking between the first connecting rod 221 and the second connecting rod 222 may also be achieved by other devices such as drive motors, gears, etc. disposed at a connection position of the two rods, all of which are contained within the principle and spirit of the present disclosure.

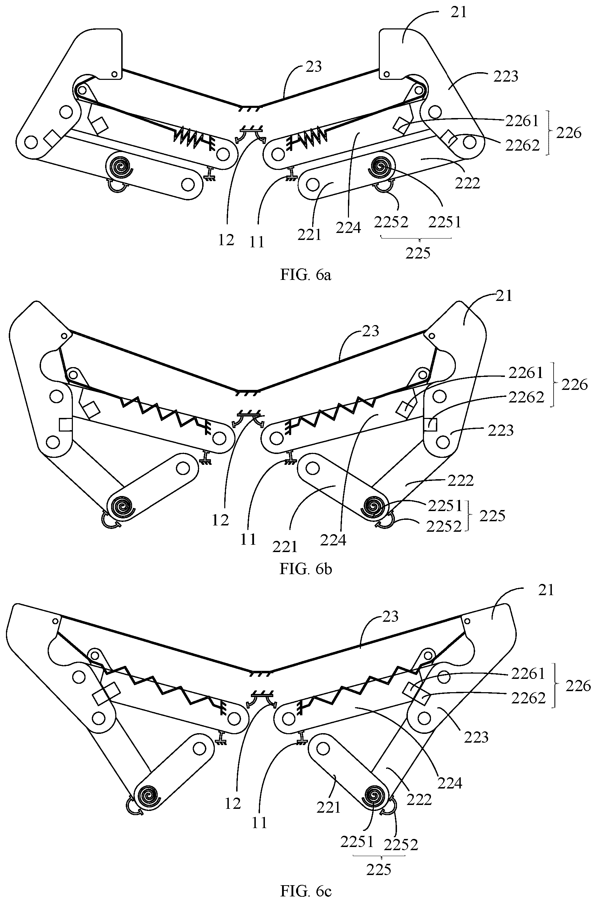

In the attachment gripping mode, also referring to FIG. 6c, the third connecting rod 223 and the fourth connecting rod 224 are locked with a predetermined angle therebetween, such that the fingertip 21 is located in the second state, and the fingertip is deflected relative to the attaching assembly in the first direction in which the gripping assemblies are away from each other. In this state, the limiting and the locking between the first connecting rod 221 and the second connecting rod 222 is disabled (e.g., in an example of using the drive motor, the drive motor for locking may be deactivated when switching to the second state) or the elastic limiting force is overcome, so that the first connecting rod 221 and the second connecting rod 222 can rotate freely relative to each other. In addition, compared with the first state, the third connecting rod 223 and the fourth connecting rod 224 are locked with a smaller angle therebetween in the second state, so that the fingertip 21 is deflected towards the outer side of the gripping assembly, i.e., the first direction relative to the attaching assembly 23. Therefore, in the second state, when the gripping device 1 grips the target object through the attaching assemblies 23, the fingertips 21 do not touch the target object, avoiding damaging the fragile or deformable target objects. For example, in some embodiments, an angle between the gripping surface of the fingertip 21 for gripping the target object and a plane in which the attaching assembly 23 is located is greater than or equal to 180 degrees. The gripping device 1 is able to grip objects through the attaching assemblies 23 provided on the inner sides of the connecting rod assemblies 22.

In this embodiment, the first connecting rod and the second connecting rod are locked in the same line to achieve the first state of the fingertip, and the third connecting rod and the fourth connecting rod are locked with the predetermined angle therebetween to achieve the second state of the fingertip. The gripping modes and the fingertip states are switched by the position change of the connecting rods, which does not require additional drive mechanisms, making the structure of the gripping device simple and less costly.

In some embodiments, each connecting rod assembly 22 further includes a second locking assembly 226 for locking the third connecting rod 223 and the fourth connecting rod 224 with the predetermined angle therebetween in the attachment gripping mode.

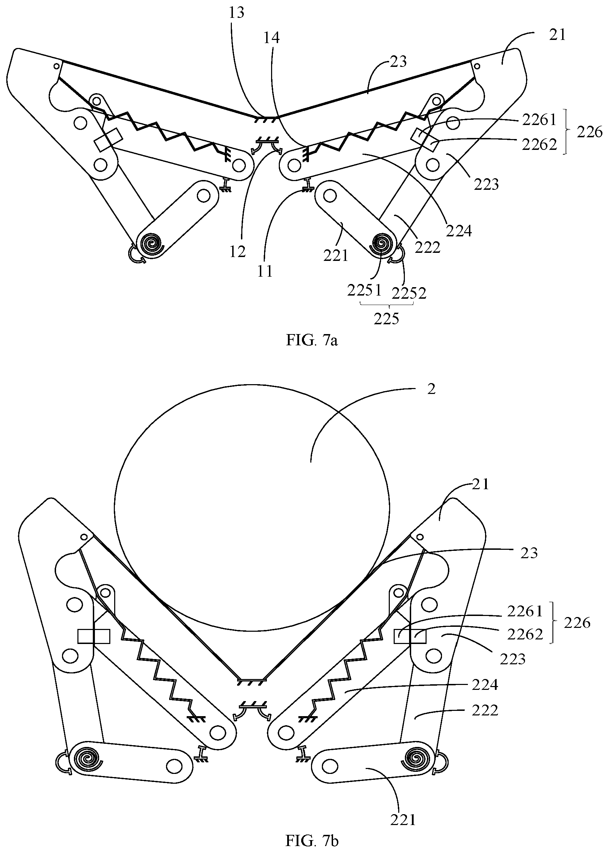

In some embodiments, referring to FIG. 3 and FIGS. 7a-7b, the second locking assembly 226 includes a first locking element 2261 and a second locking element 2262. The first locking element 2261 is disposed on the fourth connecting rod 224. The second locking element 2262 is disposed on the third connecting rod 223. The first locking element 2261 and the second locking element 2262 are configured to cooperate to lock or unlock the third connecting rod 223 and the fourth connecting rod 224. When the third connecting rod 223 and the fourth connecting rod 224 are in a position relationship with the predetermined angle therebetween, the first locking element 2261 and the second locking element 2262 cooperate to secure the related position relationship between the third connecting rod 223 and the fourth connecting rod 224.

For example, in some embodiments, the first locking element 2261 and the second locking element 2262 are magnets. The third connecting rod 223 and the fourth connecting rod 224 are locked with the predetermined angle therebetween by the magnetic force between the two magnets. At least one of the third connecting rod 223 and the fourth connecting rod 224 is provided with a mounting slot 2263 for receiving the magnet and adjusting the position of the magnet. For example, in some embodiments, the mounting slot 2263 may be a cavity in which the magnet is mounted. The mounting slot 2263 may also be provided with an adjusting element for adjusting the position of the magnet in the mounting slot 2263.

For another example, in some other embodiments, the first locking element 2261 and the second locking element 2262 may be a pair of snap structures. The third connecting rod 223 and the fourth connecting rod 224 are locked with the predetermined angle therebetween by means of the snap fastening.

It should be understood that the locking provided by the second locking assembly 226 by means of the magnet suction and the snap fastening may be considered as a passive locking. In the passive locking mode, a magnitude of the locking force and a magnitude of the force required to release the passive locking can be set according to the actual situation, as long as it ensures that the third connecting rod 223 and the fourth connecting rod 224 can be locked at all times in the second gripping mode, and can be unlocked during the switching from the second gripping mode to the first gripping mode. Examples of the specific mode switching will be described below.

For another example, in some embodiments, the second locking assembly 226 may also be an electromagnetic clutch provided in the third connecting rod 223 or the fourth connecting rod 224. In the fingertip gripping mode, the electromagnetic clutch is de-energized, and the third connecting rod 223 and the fourth connecting rod 224 are free to rotate. In the attachment gripping mode, the electromagnetic clutch is energized, and the third connecting rod 223 and the fourth connecting rod 224 are locked with the predetermined angle therebetween. In some other embodiments, the relative rotation and the limitation locking of the third connecting rod 223 and the fourth connecting rod 224 may also be achieved by devices such as a drive motor, or a gear, etc. provided at the connection position of the two rods. The method for locking the two connecting rods is not limited in the present disclosure.

It should be understood that the locking provided by the second locking assembly 226 by means of the electromagnetic clutch or the drive motor may be considered as an active locking. In the active locking mode, instructions for locking and unlocking may be sent to the second locking assembly 226 by a corresponding processor according to operational requirements of the gripping device.

Referring to FIG. 4, the casing 10 further includes first limiting elements 11 and second limiting elements 12. The first limiting elements 11 and the second limiting elements 12 are respectively disposed on two sides of the fourth connecting rods 224 to limit rotation ranges of the fourth connecting rods 224 in corresponding directions. For example, as shown in FIG. 4, each first limiting element 11 is disposed on the casing 10 and is located adjacent to a side of the fourth connecting rod 224 facing the first connecting rod 221. Each first limiting element 11 is configured to limit the rotation range of the fourth connecting rod 224 in the first direction when the gripping assemblies 20 rotate away from each other in the first direction. Each second limiting element 12 is disposed on the casing 10 and is located adjacent to a side of the connecting rod 224 facing the attaching assembly 23, and is configured to limit the rotation range of the fourth connecting rod 224 in the second direction when the gripping assemblies 20 rotate close to each other in the second direction. The first limiting elements 11 and the second limiting members 22 may be slots or protruding blocks etc. that can provide the position limitation. The specific structures of the first limiting elements 11 and the second limiting elements 12 are not limited, as long as the position limitation can be achieved. By limiting the rotation ranges of the fourth connecting rods by the limiting elements, the gripping device can achieve the mode switching through a simple mechanical structure without a need for additional drive devices, resulting in a simple structure and a lower cost. The specific mode switching will be described below.

The drive device 30 is disposed in the casing 10 to drive rotation of the first connecting rods 221 and/or the fourth connecting rods 224 to open and close the gripping assemblies 20, so as to achieve the gripping and releasing operation. The drive device 30 may include any mechanism such as a motor capable of driving the gripping assemblies 20 to rotate, and will not be described in detail herein. In the following description of the operation process, the drive device driving the first connecting rod 221 will be used as an example.

The operation process of the gripping device 1 will be described illustratively below with reference to FIGS. 5a-8c.

FIGS. 5a-5b show the movement of the at least two gripping assemblies 20 when gripping the target object 2 in the fingertip gripping mode. In the fingertip gripping mode, the first connecting rod 221 and the second connecting rod 222 are locked in the same line, the remaining connecting rods can rotate freely, and the second locking assembly 226 is inactive. The direction of the gripping surface of the fingertip 21 touching the target object remains unchanged when the gripping assemblies 20 are moving close to each other or moving away from each other, i.e., the fingertip is in the first state.

FIG. 5a illustrates the state when the at least two gripping assemblies 20 are open in the fingertip gripping mode. In the fingertip gripping mode, the first connecting rods 221 or the fourth connecting rods 224 are driven to rotate by the drive device 30, causing the gripping assemblies 20 to move close to each other. When the gripping assemblies 20 are rotating to the state shown in FIG. 5b, the fingertips 21 move to the target object and clamp the target object. In this process, by reasonably adjusting the position of the gripping device and the target object, the attaching assemblies 23 can be kept from contacting with the target object.

FIGS. 6a-6c are equivalent schematic diagrams showing the process of the switching of the gripping device 1 from the fingertip gripping mode to the attachment gripping mode.

In the fingertip gripping mode shown in FIG. 6a, as the drive device 30 drives the gripping assemblies 20 to rotate away from each other, the gripping assemblies 20 gradually open. When the fourth connecting rods 224 are rotating to the first limiting elements 11, the fourth connecting rods 224 are restricted by the first limiting elements 11 and cannot continue to rotate. Meanwhile, the drive device 30 continues to drive the first connecting rods 221 to rotate, so that the first connecting rods 221 and the second connecting rods 222 are released from the locking of the first locking assemblies 225 and rotate relatively. Meanwhile, the second connecting rods 222 drive the third connecting rods 223 to continue to rotate, thus, the third connecting rods 223 deflect in the first direction relative to the fourth connecting rods 224, as shown in FIG. 6b. Finally, the gripping assemblies 20 rotate to a state in which the third connecting rods 223 and the fourth connecting rods 224 move to the predetermined angle and are locked by the second locking assemblies 226, as shown in FIG. 6c, the gripping device 1 is switched to the attachment gripping mode. At this point, the fingertip 21 of each gripping assembly 20 is in the second state. For example, an angle between the surface of each fingertip 21 for gripping the target object and the plane of the attaching assembly 23 is large (for example, equal to or greater than 180 degrees). Therefore, when the gripping device 1 grips the target object by the attaching assemblies 23, the fingertips 21 do not touch the target object.

FIGS. 7a to 7b show the movement of the gripping assemblies 20 in the attachment gripping mode.

FIG. 7a shows an opening state of the gripping assemblies 20 in the attachment gripping mode. During the gripping process, the gripping assemblies 20 are driven by the drive device 30 to rotate close to each other until the attaching assemblies 23 adheres to or adsorbs the target object 2, as shown in FIG. 7b. During the rotation, the angle between the third connecting rod 223 and the fourth connecting rod 224 remain at the predetermined angle, and the relative positions of the third connecting rod 223 and the fourth connecting rod 224 remain unchanged.

Referring to FIGS. 3-4 and FIGS. 8a-8c, the switching of the gripping device 1 from the attachment gripping mode to the fingertip gripping mode will be described below.

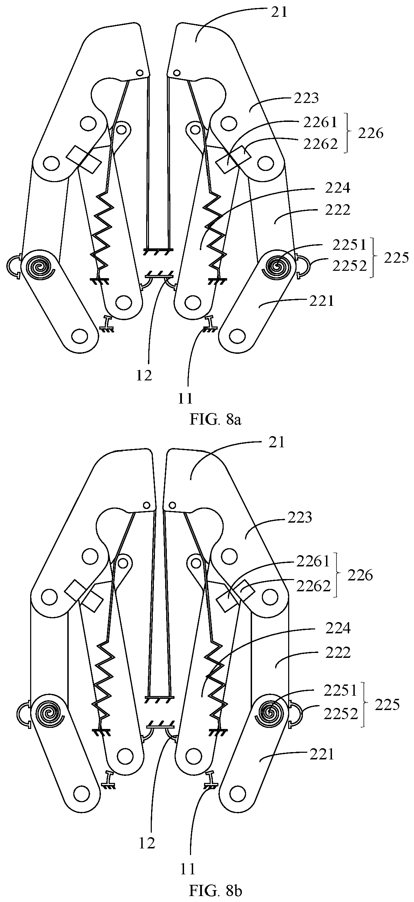

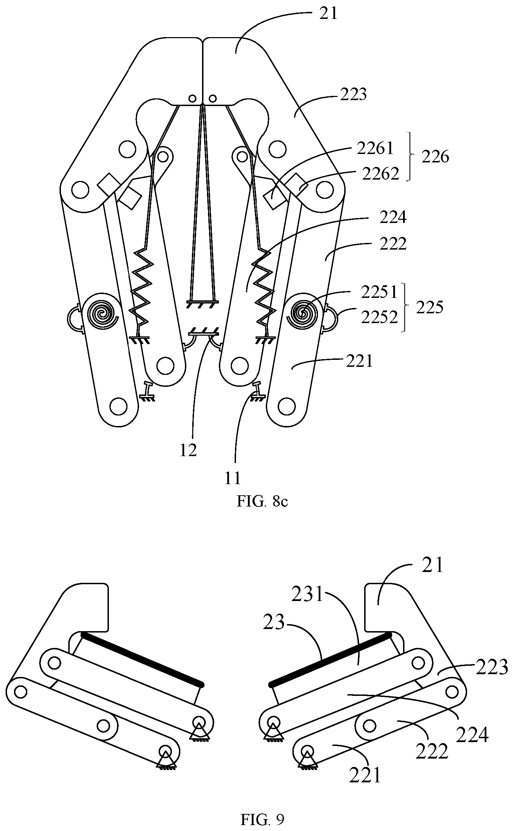

In the attachment gripping mode, as the drive device 30 drives the gripping assemblies 20 to rotate close to each other, as shown in FIG.S 8a-8b, the gripping assemblies 20 are gradually closed. When the fourth connecting rods 224 are rotating to the second limiting elements 12, the fourth connecting rods 224 are restrained by the second limiting elements 12 and cannot continue to rotate. At this point, the drive device 30 drives the first connecting rods 221 of the gripping assemblies to continue to rotate close to each other in the second direction, and the third connecting rods 223 are driven to continue to rotate, so that the locking of the third connecting rods 223 and the fourth connecting rods 224 are released by the driving force of the drive device 30. When the locking of the third connecting rods 223 and the fourth connecting rods 224 are released, the first connecting rods 221 and the second connecting rods 222 return to the state in the first gripping mode of the gripping device by the action of the first locking assemblies 225, i.e., the first connecting rod 221 and the second connecting rod 222 are in the same line and are locked by the first locking assembly 225, as shown in FIG. 8c. At this point, the locking of the relative position of the third connecting rods 223 and fourth connecting rods 224 by the second locking assemblies 226 are released, and the gripping device 1 is switched from the attachment gripping mode to the fingertip gripping mode.

It should be understood that if the first locking assemblies 225 and the second locking assemblies 226 are in the active locking mode, the switching between the fingertip gripping mode and the attachment gripping mode may be performed by a software program which controls the drive device 30 in response to a user's switching instruction.

In the gripping device provided by this embodiment, by providing the attaching assemblies on the inner sides of the connecting rod assemblies, the gripping device can implement an accurate gripping in the fingertip gripping mode, and can grip large objects, or fragile or deformable objects in the attachment gripping mode. The two gripping modes do not affect each other, and the gripping device can be thus adapted to more scenarios. In addition, the switching between the two modes can be achieved by adjusting the positions of the four connecting rods, the structure is simple, and no additional controller or driver is required, thus reducing the complexity of the system. Besides, the position change of the fingertips can avoid the damage to the target objects in the attachment gripping mode. In addition, by providing the imitation gecko adhesive material film having a constant tension, the length of the attachment assembly toward the target object can be adjusted, which can grasp larger target objects and can provide more reliable wrapping force.

The attaching assemblies 23 in some embodiments of the present disclosure will be described below with reference to FIGS. 1-4, FIG. 9, and FIG. 11.

The attaching assemblies 23 are provided on the sides of the connecting rod assemblies 22 facing the target object to be gripped when gripping the target object, i.e., on the sides of the at least two gripping assemblies 20 facing each other (i.e., the inner sides of the connecting rod assemblies 22 in the drawings). The attaching assemblies 23 are configured to grip the target object by means of adsorption or adhesion in the attachment gripping mode. The casing 10 further includes a first fixing element 13 and second fixing elements 14. The attaching assemblies 23 are connected between the casing 10 and the fingertips 21 by the first fixing element 13 and the second fixing elements 14.

In some embodiments, each attaching assembly 23 is a strip of gecko adhesive material film. The gecko adhesive material film is disposed along the length of the connecting rod assembly 22. The gecko adhesive material was designed by inspiration of the gecko, and has a structure imitating the gecko's foot. The surface of the gecko adhesive material film is provided with a plurality of micro-wedge structures that are capable of adhering to a surface of an object by intermolecular interactions (e.g., Van der Waals forces). In the attachment gripping mode, the gripping operation is implemented by adhering to the surface of the target object by the gecko adhesive material film. Since the gecko adhesive material film is prior art, it will not be described in detail here.

By using the reliable adhesion ability of the gecko adhesive material film, it is possible to achieve a stable gripping, and avoid damage to the target object under the minimum pressure applied to the target object.

In some embodiments, a first end of the gecko adhesive material film is fixed to the casing 10 near the fourth connecting rod 224 by the first fixing element 13, and a second end of the gecko adhesive material film is connected to an end of the connecting rod assembly 22 near the fingertip 21 by the second fixing element 14. At least one of the first fixing element 13 and the second fixing element 14 is capable of providing a substantially constant loading force to the gecko adhesive material film. The loading force is in the direction of the length of the connecting rod assembly, such that the gecko adhesive material film is capable of stretching and retracting as the gripping assembly 20 opens and closes, and the attaching assembly is always in a tensioned state throughout the movement of the gripping assembly.

For example, referring to FIGS. 3-4, in some embodiments, the first fixing element 13 is disposed on the casing 10, and is located between the at least two gripping assemblies 20. The first fixing element 13 is configured to connect the first ends of the gecko adhesive material films. Each fingertip 21 is provided with a first roller 227, and each fourth connecting rod 224 is provided with a second roller 228. Each second fixing element 14 is disposed between the corresponding gripping assembly 20 and the first fixing element 13. The first end of the gecko adhesive material film is connected to the first fixing element13, the main body of the gecko adhesive material film is wrapped around the first roller 227 and the second roller 228 in turn, and the second end of the gecko adhesive material film is connected to the second fixing element14.

The second fixing elements 14 provide the substantially constant loading forces for the gecko adhesive material films 23. As the gripping assemblies 20 open and close, the lengths of the attaching assemblies 23 exposed between the first fixing element 13 and the fingertips 21 change accordingly, allowing for larger objects to be gripped in the attachment gripping mode. Besides, the gecko adhesive material films also have great elastic deformation, which facilitates the protection of the deformable or fragile target objects.

The substantially constant loading force may be provided by means of an elastic member (e.g., a spring with constant force), or by means of a rotating shaft capable of providing the constant loading force. The substantially constant loading force allows the attaching assemblies 23 to be kept in the tensioned state during the movement of the gripping assemblies, avoiding occurrence of wrinkles in the gecko adhesive material films during the stretching and retracting process, and thus providing a more reliable wrapping force and adhesive force to the target object.

For another example, in some other embodiments, the second fixing elements 14 may also be provided at the end of the fourth connecting rods 224 near the fingertips 21. At least one of the first fixing element 13 and the second fixing elements 14 provides the substantially constant loading force for the gecko adhesive material films without the need for the two rollers as described above.

It should be understood that in some embodiments, the attaching assemblies 23 may be provided on each of the gripping assemblies 20 correspondingly. If there are more gripping assemblies 20, the attaching assemblies 20 may be provided on only part of the gripping assemblies 20. For example, if the gripping device 1 includes four gripping assemblies, the attaching assemblies may be provided on two of the gripping assemblies. The attaching assemblies may be arranged according to actual needs.

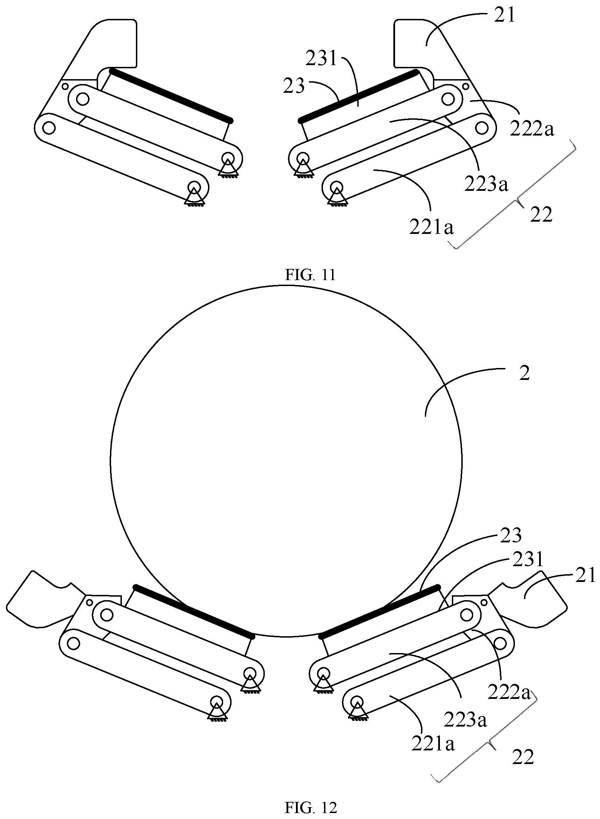

In other embodiments, as shown in FIG. 9 and FIG. 11, the attaching assemblies 23 may also be affixed directly to the side of the connecting rod assemblies 22 facing the target object.

Specifically, in this embodiment, the structure of each connecting rod assembly 22 is similar to that in the embodiments shown in FIGS. 1 to 4. Each connecting rod assembly 22 includes a first connecting rod 221, a second connecting rod 222, a third connecting rod 223, and a fourth connecting rod 224. The attaching assembly 23 is affixed to the side of the fourth connecting rod 224 facing the target object. Since the attaching assembly 23 is directly affixed to each fourth connecting rod 224, there is no need for the first fixing element and the second fixing elements on the casing 10 for fixing the attaching assemblies 23, the first rollers and the second rollers. Therefore, the structure of the gripping device is further simplified. The working process under the fingertip gripping mode and the attachment gripping mode and the switching between the fingertip gripping mode and the attachment gripping mode can be referred to the previous embodiments, and will not be repeated here.

In some embodiments, a cushion 231 is provided between the attaching assembly 23 and the connecting rod assembly 22. For example, the gecko adhesive material is fixed to the cushion 231, and then fixed to the fourth connecting rod 224 by the cushion 231. The cushion 231 may be made of a flexible and deformable material, such as rubber, foam, etc.

In some other embodiments, the attaching assemblies 23 may also be a material with an adhesive function such as the gecko adhesive material that is directly coated on the connecting rod assemblies.

In some other embodiments, the attaching assemblies 23 may also be one or more vacuum adsorption devices, such as suction cups, disposed on the connecting rod assemblies 22. The attaching assemblies 23 can grip the target object by suction of the suction cups in the attachment gripping mode.

It should be understood that the attaching assemblies 23 in this disclosure may also be any other structures or materials capable of gripping or releasing the target object by means of adsorption or adhesion. The structure and the material of the attaching assemblies are not limited in this disclosure, as long as the attaching assemblies can grip the object by means of adsorption or adhesion, and all of them are contained within the scope of protection of this disclosure.

FIGS. 11 to 12 are schematic diagrams showing a structure of the gripping device in another embodiment of the present disclosure. In this embodiment, each of the fingertips 21 is rotatably connected to the first end of the corresponding connecting rod assembly 22.

When the gripping device 1 is in the fingertip gripping mode, each fingertip 21 is in the first state, as shown in FIG. 11. The gripping surface of each fingertip 21 for gripping the target object remains in the same direction during the gripping assemblies moving close to or away from each other. When the at least two gripping assemblies 20 move to a closed state, the fingertips 21 of the gripping assemblies 20 face each other and cooperate with each other to clamp the target object. By rotating the fingertips 21 in a direction away from the attaching assemblies 23, the gripping device 1 can be switched from the fingertip gripping mode to the attachment gripping mode. As shown in FIG. 12, at this point, the fingertips are in the second state, i.e., each fingertip is deflected in the first direction relative to the attaching assembly, such that the fingertips 21 do not contact the target object when the gripping device 1 grips the target object in the attachment gripping mode.

In this embodiment, the fingertips 21 may be rotatably connected to the first ends of the connecting rod assemblies 22 by hinges. The method for driving the fingertips 21 to rotate is not limited in the present disclosure. The fingertips 21 may be rotated to the first state and the second state manually, or the fingertips 21 may be driven to the first state and the second state by a drive device such as a drive motor.

In some further embodiments, the connecting rod assemblies 22 may be further simplified when the fingertips 21 are rotatably connected to the connecting rod assemblies 22. For example, as shown in FIG. 12, in an embodiment, each connecting rod assembly 2 may include three connecting rods rotatably connected in sequence, i.e., a first connecting rod 221a, a second connecting rod 222a, and a third connecting rod 223a. A free end of the first connecting rod 221a and a free end of the third connecting rod 223a are rotatably connected to the casing 10. The first connecting rod 221a, the second connecting rod 222a, the third connecting rod 223a and the casing 10 jointly form a parallelogram structure. The fingertip 21 is rotatably connected to the end of the second connecting rod 222a near the third connecting rod 223a. The attaching assembly 23 is fixedly disposed on a side of the third connecting rod 223a facing the target object to be gripped. The method for mounting the attaching assembly 23 can be referred to the embodiments as previously described and will not be repeated here.

In the gripping device provided in this embodiment, each fingertip 21 is switched between the first state and the second state by rotation, making the design of the connecting rod assemblies 22 simpler.

In other optional embodiments, the fingertips 21 may also be removably connected to the first ends of the connecting rod assemblies 22. In the fingertip gripping mode, the fingertips 21 are mounted to the end of the connecting rod assemblies 22. In the attachment gripping mode, the fingertips 21 may be manually removed. The fingertips 21 may be removably mounted to the connecting rod assemblies 22 by screws, snaps, etc., or may be removably mounted to the connecting rod assemblies 22 by plugging, etc. The method for mounting the fingertips is not limited in this disclosure.

It should be understood that in some other optional embodiments, it is possible that the state of each of the fingertips 21 is not changed in the first gripping mode and in the second gripping mode.

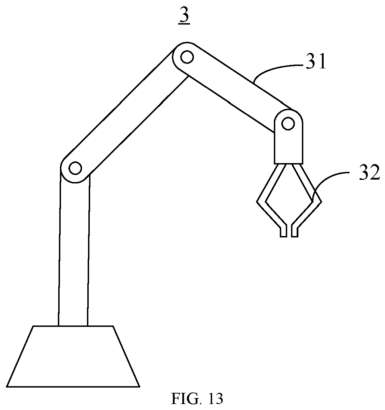

Based on the above concept, as shown in FIG. 13, the present disclosure further provides a robot 3. The robot 3 may include at least one connecting member 31 and at least one gripping device 32. The robot 3 may be configured to grip or capture a target object. In particular, the gripping device 32 may be any gripping device as described in the previous embodiments. It should be understood by those of ordinary skill in the art that the structure shown in FIG. 13 is only an exemplary embodiment of the robot 3. In other embodiments, the robot 3 may include more components or fewer components. For example, the robot may also include an input and output device, a network access device, a communication bus, a processor, a memory, an actuator, and sensors, etc. These additional components may implement a control system, for example, these additional components may implement the switching instructions discussed above. For example, the robot 3 may also include a processor and a memory for storing instructions, and when executed by the processor, the instructions cause the processor to implement the control system. The memory may also store instructions that, when executed by the processor, cause the processor to activate or deactivate the gripping device 32 in order to grip or release the target object to be gripped.

Finally, it should be noted that the above embodiments are only used to illustrate the technical solution of this disclosure, but not to limit the present disclosure. Although the disclosure is illustrated in detail with reference to the foregoing embodiments, it should be understood by those of ordinary skill in the art that it is still possible to modify the technical solutions recorded in the foregoing embodiments, or to replace some or all of the technical limitations therein. These modifications or replacements do not make the essence of the corresponding technical solutions out of the scope of the technical solutions of the embodiments of the present disclosure, which should be covered by the scope of the claims and the specification of the present disclosure. In particular, the technical limitations mentioned in each embodiment can be combined in any way, as long as there is no structural conflict. The present disclosure is not limited to the particular embodiments disclosed in the context, but includes all technical solutions that fall within the scope of the claims.

## Claims

1. A gripping device, comprising:
a casing; and
at least two gripping assemblies configured to grip a target object cooperatively, each of the gripping assemblies comprising:
a fingertip configured to clamp the target object;
a connecting rod assembly, a first end of the connecting rod assembly being connected to the fingertip, and a second end of the connecting rod assembly being rotatably connected to the casing; and
an attaching assembly disposed on a side of the connecting rod assembly facing the target object to be gripped;
wherein the gripping device is configured to be switched between a first gripping mode and a second gripping mode,
in the first gripping mode, the gripping device clamps the target object by the fingertips cooperating with each other; and
in the second gripping mode, the gripping device adheres and/or adsorbs the target object by the attaching assemblies cooperating with each other to implement a gripping operation.

2. The gripping device according to claim 1, wherein each fingertip is in a first state in the first gripping mode, and each fingertip is in a second state in the second gripping mode, wherein when each fingertip is in the second state, each fingertip is deflected relative to the attaching assembly in a first direction in which the gripping assemblies are away from each other.

3. The gripping device according to claim 2, wherein each connecting rod assembly comprises a first connecting rod, a second connecting rod, a third connecting rod, and a fourth connecting rod,
wherein a first end of the first connecting rod is rotatably connected to the casing, and a second end of the first connecting rod is rotatably connected to the second connecting rod;
a first end of the second connecting rod is rotatably connected to the first connecting rod, and a second end of the second connecting rod is rotatably connected to a first end of the third connecting rod;
a first end of the third connecting rod is connected to the second end of the second connecting rod, and a second end of the third connecting rod is connected to the fingertip ;
a first end of the fourth connecting rod is connected between the first end of the second connecting rod and the fingertip , and a second end of the fourth connecting rod is rotatably connected to the casing; and
the attaching assembly is disposed on a side of the fourth connecting rod facing the target object to be gripped.

4. The gripping device according to claim 3, wherein the connecting rod assembly further comprises a first locking assembly, in the first gripping mode, the first connecting rod and the second connecting rod are locked in a same line by the first locking assembly, and the fingertip is in the first state.

5. The gripping device according to claim 3, wherein the connecting rod assembly further comprises a second locking assembly, in the second gripping mode, the third connecting rod and the fourth connecting rod are locked with a predetermined angle therebetween by the second locking assembly, and the fingertip is in the second state.

6. The gripping device according to claim 3, wherein the casing further comprises first limiting elements and second limiting elements, the first limiting elementsand the second limiting elements are respectively disposed on two sides of the fourth connecting rods,
wherein the first limiting elements are configured to limit rotation ranges of the fourth connecting rods in the first direction when the gripping assemblies are rotated away from each other in the first direction, and the second limiting elements are configured to limit rotation ranges of the fourth connecting rods in a second direction when the gripping assemblies are moving close to each other in the second direction.

7. The gripping device according to claim 3, wherein each connecting rod assembly further comprise a first locking assembly and a second locking assembly, and the casing further comprises first limiting elements and second limiting elements,
wherein the first locking assembly is configured to lock the first connecting rod and the second connecting rod in a same line in the first gripping mode, and the second locking assembly is inactive in the first gripping mode;
the second locking assembly is configured to lock the third connecting rod and the fourth connecting rod with a predetermined angle therebetween in the second gripping mode, and the first connecting rod and the second connecting rod are released from the locking of the first locking assembly;
the first limiting elements and the second limiting elements are disposed on two sides of the fourth connecting rod;
wherein, during switching the gripping device from the first gripping mode to the second gripping mode, the first limiting elements are configured to limit rotation ranges of the fourth connecting rods in the first direction when the gripping assemblies are rotated away from each other in the first direction, such that the first connecting rod and the second connecting rod are released from the locking of the first locking assembly to rotate relative to each other, and the third connecting rod rotates relative to the fourth connecting rod in the first direction to the predetermined angle and are locked by the second locking assembly; and
wherein, during switching the gripping device from the second gripping mode to the first gripping mode, the second limiting elements are configured to limit rotation ranges of the fourth connecting rods in a second direction when the gripping assemblies move close to each other in the second direction, such that the first connecting rod drives the third connecting rod to rotate when the first connecting rod continues to rotate in the second direction, causing the second locking assembly to unlock the third connecting rod and the fourth connecting rod and causing the first locking assembly to lock the first connecting rod and the second connecting rod.

8. The gripping device according to claim 2, wherein each connecting rod assembly comprises a first connecting rod, a second connecting rod, and a third connecting rod,
wherein a first end of the first connecting rod is rotatably connected to the casing, and a second end of the first connecting rod is rotatably connected to a first end of the second connecting rod;
a second end of the second connecting rod is rotatably connected to the fingertip ;
a first end of the third connecting rod is rotatably connected between the second end of the second connecting rod and the fingertip, and a second end of the third connecting rod is rotatably connected to the casing; and
the attaching assembly is disposed on a side of the third connecting rod facing the target object to be gripped.

9. The gripping device according to any one of claims 1 to 8, wherein the casing further comprises a first fixing element and a second fixing element, the attaching assemblies are connected between the casing and the fingertip by the first fixing element and the second fixing element, and the attaching assemblies each have a substantially constant loading force.

10. The gripping device according to claim 9, wherein at least one of the first fixing element and the second fixing element is configured to provide the substantially constant loading force to the attaching assembly, such that the attaching assembly remains in a tensioned state during movement of the gripping assemblies .

11. The gripping device according to any one of claims 1-8, wherein the attaching assembly is mounted on one side of the connecting rod assembly facing the target object to be gripped by means of attachment fixation.

12. The gripping device according to claim 1, wherein the attaching assemblies are gecko adhesive material films.

13. The gripping device according to claim 12, wherein the attaching assemblies are fixedly attached to the connecting rod assemblies by means of a cushion, respectively.

14. A robot, comprising a gripping device according to any one of claims 1 to 13.
